# FASCICULE DE BREVET EUROPEEN

(11) **EP 4 402 727 B1**
(45) Date de publication et mention de la délivrance du brevet: **15.07.2026**
(21) Numéro de dépôt: 22783542.8
(22) Date de dépôt: 12.09.2022
(51) Int. Cl.: H10F 19/80, H10F 19/85

(54) **MODULE PHOTOVOLTAÏQUE LÉGER COMPORTANT UNE COUCHE AVANT EN VERRE ET POLYMÈRE**
LEICHTES FOTOVOLTAISCHES MODUL MIT EINER GLAS- UND POLYMERFRONTSCHICHT
LIGHTWEIGHT PHOTOVOLTAIC MODULE COMPRISING A GLASS AND POLYMER FRONT LAYER

(30) Priorité: 14.09.2021 FR 2109635
(43) Date de publication de la demande: 24.07.2024
(73) Titulaire: Commissariat à l'Energie Atomique et aux Energies Alternatives, 75015 Paris (FR)
(72) Inventeur: GAUME, Julien, 38054 GRENOBLE Cedex 09 (FR); FRANCOIS, Jérôme, 38054 GRENOBLE CEDEX 09 (FR); COMMAULT, Benjamin, 38054 GRENOBLE cedex 09 (FR); CHAMBION, Bertrand, 38054 GRENOBLE CEDEX 09 (FR); VESCHETTI, Yannick, 38054 GRENOBLE Cedex 09 (FR)
(74) Mandataire: Regimbeau
(86) Numéro de dépôt international: PCT/FR2022/051713
(87) Numéro de publication internationale: WO 2023/041864

(56) Documents cités:
- CN-A- 107 994 086
- US-A1- 2009 272 436
- US-A1- 2010 065 116
- US-A1- 2014 083 490
- US-A1- 2019 172 962

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, notamment civiles et/ou militaires, par exemple des applications autonomes et/ou embarquées, étant particulièrement concernée par les applications qui requièrent l'utilisation de modules photovoltaïques légers et rigides, en particulier d'un poids par unité de surface inférieur à 5 kg/m², voire 6 kg/m². Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, entre autres.

L'invention propose ainsi un module photovoltaïque léger obtenu par un empilement comportant une première couche en verre et polymère formant la face avant du module, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Il est à noter que les cellules photovoltaïques de type IBC (« Interdigitated Back Contact ») sont des structures pour lesquelles les contacts sont réalisés sur la face arrière de la cellule en forme de peignes interdigités. Elles sont par exemple décrites dans le brevet américain US 4,478,879 A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

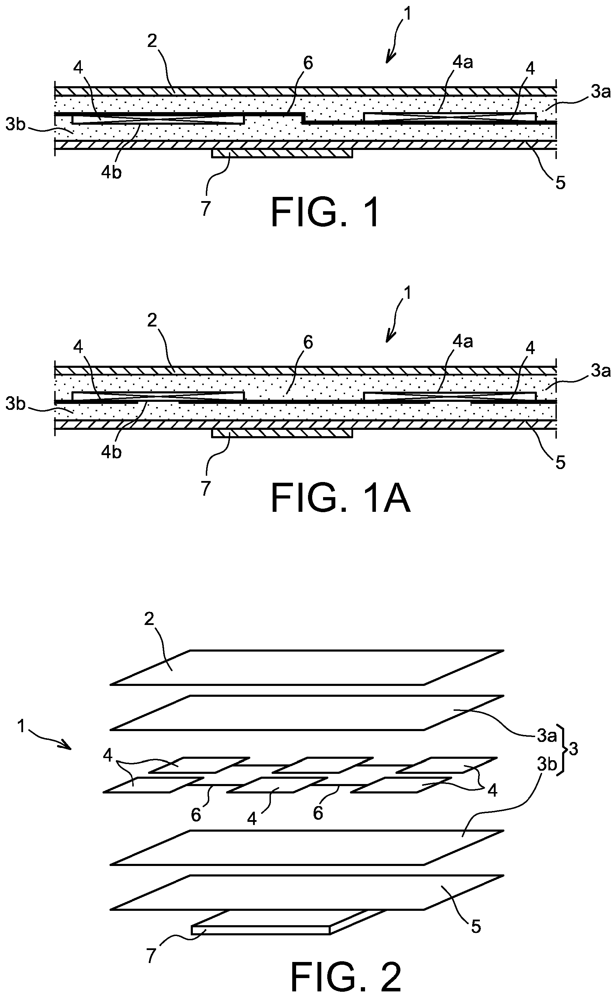

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

La figure 1A représente en outre une variante de réalisation de l'exemple de la figure 1 dans laquelle les cellules photovoltaïques 4 sont de type IBC, les conducteurs de liaison 6 étant uniquement disposés contre les faces arrières des cellules photovoltaïques 4.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 165°C, et pendant une durée du cycle de lamination généralement d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche avant de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais et du cadre aluminium, lui permettant, notamment et dans la majorité des cas, de respecter les normes IEC 61215 et IEC 61730.

Néanmoins, un tel module photovoltaïque 1 selon la conception classique de l'art antérieur présente l'inconvénient d'avoir un poids relativement élevé, en particulier un poids par unité de surface d'environ 10 à 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre aluminium. Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 2 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans des applications exigeantes en termes de légèreté, par exemple les toitures commerciales, il existe un besoin pour trouver une solution alternative à l'utilisation d'un verre épais en face avant du module.

Une des possibilités consiste à remplacer la face avant en verre par des matériaux plastiques tout en conservant l'architecture et la méthode de mise en œuvre habituelles avec pour but premier la diminution importante du poids surfacique. Ainsi, des feuilles de polymères, comme le polycarbonate (PC), le polytéréphtalate d'éthylène (PET), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative au verre. Cependant, lorsque seul le remplacement du verre par une telle feuille mince de polymères est envisagé, la cellule photovoltaïque devient très vulnérable au choc, à la charge mécanique et aux dilatations différentielles.

Une alternative est l'utilisation de matériaux composites, notamment des renforts, par exemple de type fibres de verre, fibres de carbone ou fibres naturelles telles que lin, chanvre, entre autres, qui viennent en complément de l'encapsulant standard pour former un composite de type polymère/fibres associé à un film de protection polymère en face avant. Le gain de poids peut être significativement important en dépit d'une moins bonne transparence et d'une incertitude sur les aspects de performance sur des durées supérieures à 20 ans.

La suppression du verre en face avant des modules photovoltaïques a fait l'objet de plusieurs brevets ou demandes de brevet dans l'art antérieur. On peut ainsi citer à ce titre la demande de brevet FR 2 955 051 A1, la demande de brevet CN 107 994 086 A, la demande de brevet américain US 2005/0178428 A1 ou encore les demandes internationales WO 2008/019229 A2 et WO 2012/140585 A1. D'autres brevets ou demandes de brevet ont décrit l'utilisation de renforts seuls ou en composites, comme par exemple la demande de brevet européen EP 2 863 443 A1, ou encore les demandes internationales WO 2018/076525 A1, WO 2019/006764 A1 et WO 2019/006765 A1.

### EXPOSÉ DE L'INVENTION

Il existe ainsi un besoin pour concevoir une solution alternative de module photovoltaïque prévu pour être léger afin de s'adapter à certaines applications, tout en présentant des propriétés mécaniques suffisantes lui permettant d'être résistant aux chocs et à la charge mécanique, et en particulier aux normes IEC 61215 et IEC 61730.

L'invention a donc pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque obtenu à partir d'un empilement comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches,
caractérisé en ce que la première couche comporte :
- une couche avant réalisée en au moins un matériau polymère, dite « couche avant polymère », et
- au moins un ensemble avant comprenant une couche avant d'interface et une couche avant en verre, la couche avant en verre présentant une épaisseur inférieure ou égale à 2 mm, voire encore 700 µm,
ledit au moins un ensemble avant étant situé entre la couche avant polymère et l'ensemble encapsulant, et la couche avant d'interface dudit au moins un ensemble avant étant située entre la couche avant polymère et la couche avant en verre.

De façon avantageuse, l'invention permet le remplacement du verre épais standard d'épaisseur d'environ 3 mm, habituellement utilisé en face avant dans un module photovoltaïque classique, par une combinaison de couche(s) polymère(s) et de couche(s) mince(s) en verre. Ainsi, l'utilisation de verre(s) mince(s) et de polymère(s) permet d'obtenir une faible masse et une transparence équivalente à un module standard. Si l'on compare l'invention aux modules légers disponibles commercialement, la présence de verre mince dans la structure permet une meilleure résistance aux chocs, aux dilatations thermomécaniques et à la pénétration d'humidité.

Avantageusement encore, l'utilisation de matériau d'encapsulation de type polymère avec des propriétés mécaniques renforcées, notamment pour la couche arrière de matériau d'encapsulation, de l'ensemble encapsulant peut permettre d'améliorer encore la résistance aux chocs, notamment de type grêle, sur le module photovoltaïque, et de protéger les cellules photovoltaïques d'éventuels endommagements mécaniques.

Le terme « transparent » signifie que la première couche formant la face avant du module photovoltaïque est au moins partiellement transparente à la lumière visible, laissant passer au moins environ 80 % de cette lumière.

En particulier, la transparence optique, entre 300 et 1200 nm, de la première couche formant la face avant du module photovoltaïque, notamment la couche avant polymère, peut être supérieure à 80 %. De même, la transparence optique, entre 300 et 1200 nm, de l'ensemble encapsulant peut être supérieure à 90 %, tout comme celle de la couche avant d'interface.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de cœur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Par ailleurs, grâce à l'invention, il peut être possible d'obtenir un nouveau type de module photovoltaïque léger qui, par l'utilisation de verre mince, peut présenter un poids surfacique inférieur à 6 kg/m², voire 5 kg/m², tout en conservant la transparence optique de la face avant et en assurant une bonne fiabilité du module photovoltaïque avec une faible dilatation thermomécanique et une haute durabilité. De plus, l'utilisation de la couche avant polymère et de couche(s) d'interface permet de protéger le verre mince des chocs, notamment de type grêlons.

Le module photovoltaïque selon l'invention peut en outre comporter l'une ou plusieurs des caractéristiques suivantes prises isolément ou suivant toutes combinaisons techniques possibles.

La couche avant en verre peut avantageusement présenter une épaisseur inférieure ou égale à 1,5 mm, préférentiellement comprise entre 500 µm et 1,1 mm, de préférence entre 500 µm et 1 mm. Dans un mode de réalisation particulier, la couche avant en verre peut aussi avoir une épaisseur comprise entre 300 µm et 700 µm, notamment entre 300 µm et 500 µm.

Par ailleurs, la couche avant en verre peut avantageusement être réalisée en verre non trempé. Un verre non trempé est un verre qui n'a pas subi de traitement thermique ou chimique post-fabrication pour le durcir, à l'inverse d'un verre dit trempé. Autrement dit, le verre ne subit aucune trempe thermique ou chimique. En effet, le verre non trempé peut être moins résistant aux chocs, notamment ceux liés aux impacts de grêlons. Cependant, étant placé entre des couches protectrices polymères, notamment entre la couche avant polymère et la couche avant d'interface, le verre non trempé peut être protégé des chocs. Le verre non trempé peut également permettre d'assurer une barrière de protection à l'humidité pour les cellules photovoltaïques. L'utilisation de verre non trempé, plutôt que du verre trempé, peut permettre de réduire considérablement les coûts de sorte à rendre le module photovoltaïque adaptable à de nombreuses applications.

Le module photovoltaïque peut encore comporter une couche d'adhésion, par exemple sous forme de film, située entre la deuxième couche et la couche arrière de matériau d'encapsulation. La couche d'adhésion peut favoriser l'adhésion entre la deuxième couche et l'ensemble encapsulant. La couche d'adhésion peut présenter une épaisseur comprise entre 20 µm et 100 µm. Un traitement chimique ou physique de type plasma peut être utilisé pour nettoyer la surface de la deuxième couche afin de favoriser l'adhésion avec la couche d'adhésion.

La deuxième couche peut être formée par une face arrière traditionnelle, encore appelée « backsheet » en anglais. En particulier, la deuxième couche peut être formée par une structure polymérique à base d'un polymère isolant électrique. Elle peut en particulier être réalisée en au moins un matériau polymère, notamment choisi parmi : le polycarbonate (PC), le polyméthacrylate de méthyle (PMMA), le polytéréphtalate d'éthylène (PET), le polypropylène (PP), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres.

Dans le cas d'une deuxième couche sous forme de multicouche polymère, une ou plusieurs couches en aluminium peuvent être situées dans le multicouche, étant prise(s) en sandwich dans celui-ci.

Le choix d'une deuxième couche réalisée en au moins un matériau polymère peut être privilégié dans le cas où l'application finale du module photovoltaïque nécessite une surimposition de celui-ci sur un support rigide.

En outre, la suppression du verre épais en face avant du module photovoltaïque classique peut induire une perte de tenue mécanique du module. Aussi, pour pouvoir conserver un module rigide, la face arrière du module peut être prévue pour présenter une rigidité mécanique suffisante.

En particulier, selon une première possibilité, la deuxième couche peut ainsi comporter :
- une couche arrière formant un panneau arrière en matériau composite, comprenant une sous-couche principale, formant l'âme du panneau arrière, et deux sous-couches de recouvrement, formant chacune une plaque du panneau arrière, disposées de part et d'autre de l'âme de sorte que l'âme soit prise en sandwich entre les deux plaques, l'âme du panneau arrière comportant une structure alvéolaire.

L'utilisation d'une face arrière de type panneau sandwich composite peut permettre au module photovoltaïque selon l'invention d'avoir de très bonnes propriétés mécaniques et thermomécaniques tout en conservant un poids faible.

L'âme du panneau arrière peut comporter une structure alvéolaire, par exemple sous forme de nid d'abeilles, notamment réalisée en métal, par exemple aluminium, en polyimide, en polycarbonate (PC), en polypropylène (PP) ou en fibres synthétiques hautes performances, par exemple de type Nomex^{®}.

En variante, l'âme du panneau arrière peut comporter une structure alvéolaire sous forme de mousse, notamment réalisée en polytéréphtalate d'éthylène (PET), en polychlorure de vinyle (PVC) ou en polyuréthane (PU).

En outre, les plaques du panneau arrière peuvent être réalisées en matériau composite, par exemple de type prépreg fibres de verre/époxy, en métal, notamment en aluminium, en polycarbonate (PC), en polyméthacrylate de méthyle (PMMA) ou à partir de pré-imprégnés.

Les plaques du panneau arrière peuvent, le cas échéant, être recouvertes d'un film mono ou multicouche polymère, par exemple du type Tedlar^{®}.

De plus, le panneau arrière peut présenter un poids surfacique inférieur ou égal à 3 kg/m², notamment inférieur ou égal à 2 kg/m², notamment encore inférieur ou égal à 1 kg/m².

Il est à noter que, plutôt que d'avoir une face arrière de type panneau sandwich, la deuxième couche peut encore comporter une couche arrière comportant une structure alvéolaire, sans l'utilisation de sous-couches de recouvrement, par exemple une structure alvéolaire de type polycarbonate alvéolaire.

Selon une deuxième possibilité, la deuxième couche peut comporter :
- une couche arrière réalisée en au moins un matériau polymère, dite « couche arrière polymère », et
- au moins un ensemble arrière comprenant une couche arrière d'interface et une couche arrière en verre, la couche arrière en verre présentant notamment une épaisseur inférieure ou égale à 2 mm, préférentiellement encore inférieure ou égale à 1,5 mm, voire encore comprise entre 500 µm et 1,1 mm, voire encore comprise entre 500 µm et 1 mm, voire encore comprise entre 300 µm et 700 µm, voire encore entre 300 µm et 500 µm, étant notamment réalisée en verre non trempé, et présentant notamment des dimensions strictement inférieures à celles de la couche arrière polymère et notamment les mêmes dimensions et caractéristiques que celles de la couche avant en verre,
ledit au moins un ensemble arrière étant situé entre la couche arrière polymère et l'ensemble encapsulant, et la couche arrière d'interface dudit au moins un ensemble arrière étant située entre la couche arrière polymère et la couche arrière en verre.

Ainsi, la deuxième couche peut être obtenue selon un principe analogue à celui utilisé pour la première couche. En particulier, la deuxième couche peut également comporter une combinaison de verre(s) mince(s) et de polymère(s). La deuxième couche peut être ou non identique à la première couche.

Selon une troisième possibilité, la deuxième couche peut comporter une couche de renforts à base de fibres.

Par « couche de renforts à base de fibres », on entend une couche comportant majoritairement des fibres organiques et/ou inorganiques, et de préférence une couche constituée de fibres organiques et/ou inorganiques. Avantageusement, une couche de renforts à base de fibres permet un renfort mécanique à l'empilement de couches destinées à former le module photovoltaïque. Avant lamination, les fibres d'une couche de renforts à base de fibres sont préférentiellement non imprégnées, notamment par un matériau polymère. Une telle couche de renforts peut être dite fibrée, tissée ou non « sec ». En particulier, une telle couche de renforts n'est pas une couche de pré-imprégné, ni une couche composite.

La couche de renforts à base de fibres peut comporter des fibres tissées ou non tissées. Elle peut en outre présenter un poids surfacique compris entre 20 g/m² et 1500 g/m², et de préférence entre 300 g/m² et 800 g/m². Elle peut comporter des fibres de verre, de carbone, d'aramide et/ou des fibres naturelles, notamment de chanvre, de lin et/ou de soie, entre autres.

Le verre utilisé pour la couche avant en verre et/ou la couche arrière en verre peut notamment être du verre sodo-calcique, à base de silice, de calcium et de sodium.

De façon avantageuse, et applicable à tout mode de réalisation selon l'invention, la couche avant en verre peut présenter des dimensions, notamment longueur et largeur, strictement inférieures à celles de la couche avant en au moins un matériau polymère et celles de la deuxième couche. De plus, la distance séparant un bord de la couche avant en verre et un bord de la couche avant en au moins un matériau polymère ou un bord de la deuxième couche peut être strictement supérieure à 1 mm.

De façon avantageuse, la couche avant en au moins un matériau polymère et la deuxième couche peuvent présenter les mêmes dimensions, notamment longueur et largeur. De façon avantageuse encore, toutes les couches du module photovoltaïque, hormis la ou les couches en verre, peuvent présenter les mêmes dimensions, notamment longueur et largeur, celles-ci correspondant alors aux dimensions du module, la ou les couches en verre étant alors encapsulées au sein du module.

Ainsi, la couche avant en verre peut présenter des dimensions, notamment longueur et largeur, strictement inférieures à celles du module photovoltaïque, la distance séparant un bord de la couche avant en verre et un bord du module photovoltaïque étant strictement supérieure à 1 mm, de sorte que la couche avant en verre soit encapsulée au sein du module photovoltaïque.

En particulier, la couche avant en verre et/ou la couche arrière en verre peuvent présenter des dimensions, notamment une longueur et une largeur, strictement inférieures aux dimensions du module photovoltaïque obtenu par l'empilement, notamment la longueur et la largeur.

En particulier encore, l'aire d'une surface de la couche avant en verre et/ou de la couche arrière en verre, définie dans un plan transversal à la direction d'empilement, est strictement inférieure à l'aire d'une surface de toute autre couche de l'empilement dans un plan transversal à la direction d'empilement, de sorte que la couche avant en verre et/ou la couche arrière en verre soit encapsulée entre deux couches situées de part et d'autre de respectivement la couche avant en verre et/ou la couche arrière en verre.

En particulier encore, la distance séparant un bord de la couche avant en verre et/ou de la couche arrière en verre et un bord du module photovoltaïque obtenu à partir de l'empilement peut être strictement supérieure à 1 mm.

Dans le cas particulier d'un verre non trempé sensible à la casse en cas de choc sur ses bords, le fait d'avoir des dimensions réduites permet de le protéger des chocs, grâce à une encapsulation y compris sur les tranches.

En outre, la distance entre un bord d'une couche avant en verre et/ou d'une couche arrière en verre et un bord d'une cellule photovoltaïque et/ou un bord d'un conducteur de liaison reliant des cellules photovoltaïques, adjacent au bord de la couche avant en verre, peut être comprise entre 0 et 15 mm, de préférence de l'ordre de 5 mm.

Il est de plus à noter que la couche avant en verre et/ou la couche arrière en verre peuvent comporter une unique couche de verre ou correspondre à un multicouche de verre. Le cas échéant, les deux couches avant et arrière en verre peuvent être des uniques couches de verre ou des multicouches de verre, pouvant comporter ou non le même nombre de couches dans chaque multicouche. En variante, l'une peut être une unique couche de verre tandis que l'autre est un multicouche de verre.

En particulier, la couche avant en verre peut présenter des bords arrondis au niveau de ses angles, notamment avec un rayon de courbure strictement supérieur à 1 mm, de préférence strictement inférieur à 25 mm.

En outre, la couche avant en verre et/ou la couche arrière en verre peuvent présenter des bords arrondis au niveau des angles, notamment quatre bords arrondis au niveau des quatre angles d'une couche de forme carrée ou rectangulaire. En effet, en mécanique, des angles droits constituent des concentrations de contraintes et sont donc très fragiles, d'autant plus en cas de verre non trempé. L'arrondi des angles peut ainsi permettre de diminuer les contraintes subies au niveau des angles. Le rayon de courbure peut être strictement supérieur à 1 mm, de préférence à 5 mm. Le rayon de courbure peut en outre être strictement inférieur à 25 mm.

De plus, le module photovoltaïque obtenu à partir de l'empilement peut être totalement dépourvu d'un cadre métallique, notamment en aluminium. Afin d'apporter de la rigidité mécanique sur les bords et faciliter la manutention, l'empilement peut comporter un cadre en polymère positionné tout autour de la périphérie d'une couche avant en verre et/ou d'une couche arrière en verre.

Un tel cadre polymère peut être ajouté lors de la fabrication du module, positionné au contact d'une couche en verre dans un même plan.

En particulier, le module photovoltaïque peut comporter un cadre polymère disposé tout autour du pourtour de la couche avant en verre, le cadre polymère présentant notamment une largeur comprise entre 5 mm et 50 mm, préférentiellement entre 20 mm et 40 mm.

Par ailleurs, la couche avant polymère et/ou la couche arrière polymère peuvent présenter une épaisseur comprise entre 15 µm et 300 µm, notamment entre 20 µm et 50 µm.

De plus, le matériau polymère de la couche avant polymère et/ou de la couche arrière polymère peut être choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres.

En outre, la couche avant polymère et/ou la couche arrière polymère peuvent présenter un filtre de coupure UV (« UV cutoff » en anglais) compris entre 320 nm et 450 nm, ce qui correspond à la longueur d'onde pour laquelle le taux de transmission est égale à 50%. De cette façon, les couches sous-jacentes peuvent être protégées du vieillissement aux rayonnements ultraviolets (UV) et éventuellement de l'hydrolyse, ce qui procure au module photovoltaïque une durée de vie allongée.

La couche avant d'interface et/ou la couche arrière d'interface peuvent permettre le collage entre la couche avant polymère, respectivement la couche arrière polymère, et une couche en verre, ou entre deux couches en verre.

La couche avant d'interface et/ou la couche arrière d'interface peuvent présenter une épaisseur comprise entre 50 µm et 600 µm, préférentiellement entre 400 µm et 600 µm, voire encore entre 400 µm et 500 µm.

La couche avant d'interface et/ou la couche arrière d'interface peuvent présenter un module de Young compris entre 2 et 300 MPa à 25°C, préférentiellement entre 100 et 200 MPa à 25°C, voire entre 2 et 250 MPa à 25°C, voire encore entre 10 et 50 Mpa à 25°C, voire encore entre 2 et 50 Mpa à 25°C, voire encore entre 2 et 20 MPa à 25°C.

L'ensemble encapsulant peut être obtenu par la réunion d'une couche avant de matériau d'encapsulation et d'une couche arrière de matériau d'encapsulation de part et d'autre des cellules photovoltaïques, avantageusement en contact direct avec celles-ci, la couche avant de matériau d'encapsulation étant située entre la première couche et les cellules photovoltaïques.

La couche avant de matériau d'encapsulation peut être formée par au moins une couche comportant au moins un matériau d'encapsulation de type polymère ayant un module de Young à 25°C strictement inférieur à 50 MPa.

De plus, la couche arrière de matériau d'encapsulation peut être formée par au moins une couche comportant au moins un matériau d'encapsulation de type polymère ayant un module de Young à 25°C strictement supérieur à 150 MPa.

Avantageusement, l'utilisation de matériau d'encapsulation de type polymère avec des propriétés mécaniques renforcées, notamment pour la couche arrière de matériau d'encapsulation de l'ensemble encapsulant, peut permettre d'améliorer encore la résistance aux chocs, notamment de type grêle, sur le module photovoltaïque, et de protéger les cellules photovoltaïques d'éventuels endommagements mécaniques.

La couche avant de matériau d'encapsulation peut être formée par au moins une couche comportant au moins un matériau d'encapsulation de type polymère ayant un module de Young à 25°C strictement inférieur à 50 MPa, notamment supérieur à 2 MPa et strictement inférieur à 50 MPa, voire strictement inférieur à 20 MPa, notamment compris entre 10 et 20 MPa.

De plus, la couche arrière de matériau d'encapsulation peut être formée par au moins une couche comportant au moins un matériau d'encapsulation de type polymère ayant un module de Young à 25°C strictement supérieur à 200 MPa, notamment strictement supérieur à 200 MPa et inférieur à 500 MPa, notamment compris entre 250 et 350 MPa.

Par ailleurs, l'élongation à rupture de la couche avant de matériau d'encapsulation et/ou de la couche arrière de matériau d'encapsulation peut avantageusement être au minimum supérieure à 200 %.

L'utilisation d'une couche arrière de matériau d'encapsulation avec un module de Young élevé, peut permettre d'obtenir une résistance accrue aux chocs de type grêlons.

La couche avant de matériau d'encapsulation peut être formée par au moins une couche comportant au moins un matériau d'encapsulation de type polymère choisi parmi : le poly(éthylène-acétate de vinyle) (EVA), les acétals de vinyle, tels que les polyvinylbutyrals (PVB), les polyuréthanes, les élastomères de silicone, les élastomères à base de polyoléfine thermoplastique réticulée et/ou les élastomères à base de polyoléfine thermoplastique réticulée (TPO), entre autres.

La couche arrière de matériau d'encapsulation peut être formée par au moins une couche comportant au moins un matériau d'encapsulation de type polymère choisi parmi : les copolymères d'acides, les ionomères, les chlorures de polyvinyle et/ou les polyéthylènes, entre autres.

En outre, l'ensemble encapsulant, la couche avant d'interface et/ou l'éventuelle couche arrière d'interface peuvent être formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β-esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée, entre autres.

De façon préférentielle, le matériau d'encapsulation de l'ensemble encapsulant est identique au matériau de la couche avant d'interface, et de l'éventuelle couche arrière d'interface. De cette façon, il peut être possible de faciliter le procédé de fabrication.

Selon un mode de réalisation particulier, l'une des couches avant de matériau d'encapsulation et arrière de matériau d'encapsulation de l'ensemble encapsulant, notamment la couche arrière de matériau d'encapsulation, peut comporter un matériau d'encapsulation identique à celui de la couche avant d'interface, et l'autre des couches avant de matériau d'encapsulation et arrière de matériau d'encapsulation de l'ensemble encapsulant, notamment la couche avant de matériau d'encapsulation peut comporter un matériau d'encapsulation différent de celui de la couche avant d'interface.

L'ensemble encapsulant peut présenter une épaisseur comprise entre 200 µm et 600 µm, notamment entre 400 µm et 600 µm. De plus, l'ensemble encapsulant peut présenter un module de Young compris entre 2 MPa et 400 MPa à 25°C, voire entre 2 MPa et 200 MPa à 25°C.

De plus, les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS), le cuivre-indium/gallium diséléniure (CIGS), et les perovskites, entre autres.

Par ailleurs, les cellules photovoltaïques peuvent présenter une épaisseur comprise entre 1 et 300 µm, notamment entre 1 et 200 µm, et avantageusement entre 70 µm et 160 µm.

Le module photovoltaïque peut en outre comporter une boîte de jonction, destinée à recevoir le câblage nécessaire à l'exploitation du module photovoltaïque, pouvant être positionnée en face avant ou en face arrière du module, préférentiellement en face avant.

En outre, l'espacement entre deux cellules photovoltaïques voisines, ou encore consécutives ou adjacentes, peut dans certaines configurations être supérieur ou égal à 1 mm, notamment compris entre 1 mm et 30 mm, et de préférence égal à 2 mm. Dans d'autres configurations, notamment de type « shingle » selon l'appellation anglaise (ou « bardeau » en français), les cellules photovoltaïques voisines, ou encore consécutives ou adjacentes, peuvent se chevaucher ou avoir un espacement inférieur à 1 mm.

Selon un mode de réalisation particulier, la première couche peut comporter :
- un premier ensemble avant comprenant une couche avant d'interface et une couche avant en verre, la couche avant en verre présentant une épaisseur inférieure ou égale à 2 mm,
- un deuxième ensemble avant comprenant une couche avant d'interface et une couche avant en verre, la couche avant en verre présentant une épaisseur inférieure ou égale à 2 mm,
le premier ensemble avant étant situé entre la couche avant polymère et le deuxième ensemble avant, lui-même situé entre le premier ensemble avant et l'ensemble encapsulant.

L'épaisseur de la couche avant en verre du premier ensemble avant et l'épaisseur de la couche avant en verre du deuxième ensemble avant peuvent être identiques ou différentes. En particulier, l'épaisseur de la couche avant en verre du premier ensemble avant peut être supérieure à l'épaisseur de la couche avant en verre du deuxième ensemble avant.

Les dimensions de la couche avant en verre du premier ensemble avant et les dimensions de la couche avant en verre du deuxième ensemble avant peuvent avantageusement être identiques, et notamment telles que celles décrites précédemment pour la couche avant en verre.

En outre, la deuxième couche peut comporter :
- une couche arrière réalisée en au moins un matériau polymère, dite « couche arrière polymère », et
- un premier ensemble arrière comprenant une couche arrière d'interface et une couche arrière en verre, la couche arrière en verre présentant notamment une épaisseur inférieure ou égale à 2 mm, notamment inférieure ou égale à 1,5 mm, voire encore comprise entre 500 µm et 1,1 mm, voire encore comprise entre 500 µm et 1 mm, voire encore comprise entre 300 µm et 700 µm, voire encore entre 300 µm et 500 µm, et étant notamment réalisée en verre non trempé,
- un deuxième ensemble arrière comprenant une couche arrière d'interface et une couche arrière en verre, la couche arrière en verre présentant notamment une épaisseur inférieure ou égale à 2 mm, notamment inférieure ou égale à 1,5 mm, voire encore comprise entre 500 µm et 1,1 mm, voire encore comprise entre 500 µm et 1 mm, voire encore comprise entre 300 µm et 700 µm, voire encore entre 300 µm et 500 µm, et étant notamment réalisée en verre non trempé,
ledit premier ensemble arrière étant situé entre la couche arrière polymère et le deuxième ensemble arrière, lui-même situé entre le premier ensemble arrière et l'ensemble encapsulant.

Les dimensions de la couche arrière en verre du premier ensemble arrière et les dimensions de la couche arrière en verre du deuxième ensemble arrière peuvent avantageusement être identiques, et notamment telles que celles décrites précédemment pour la couche avant en verre.

De plus, l'invention a encore pour objet, selon un autre de ses aspects, un procédé de réalisation d'un module photovoltaïque, notamment tel que défini précédemment, à partir d'un empilement comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche, l'ensemble encapsulant et la pluralité de cellules photovoltaïques étant situés entre les première et deuxième couches,
caractérisé en ce que la première couche comporte :
- une couche avant réalisée en au moins un matériau polymère, dite « couche avant polymère », et
- au moins un ensemble avant comprenant une couche avant d'interface et une couche avant en verre, la couche avant en verre présentant une épaisseur inférieure ou égale à 2 mm,

ledit au moins un ensemble avant étant situé entre la couche avant polymère et l'ensemble encapsulant, et la couche avant d'interface dudit au moins un ensemble avant étant située entre la couche avant polymère et la couche avant en verre,
et en ce que le procédé comporte l'étape de lamination à chaud et sous vide des couches constitutives de l'empilement pour obtenir le module photovoltaïque.

L'étape de lamination à chaud et sous vide peut en particulier être réalisée à une température supérieure ou égale à 120°C, voire 140°C, voire encore 150°C, et inférieure ou égale à 170°C, voire 180°C, typiquement comprise entre 130°C et 180°C, voire entre 145°C et 165°C, et pendant une durée du cycle de lamination d'au moins 5 minutes, voire 10 minutes, voire 15 minutes, notamment comprise entre 5 et 20 minutes.

Ainsi, il est possible d'obtenir une encapsulation totale du verre mince permettant de le protéger face aux chocs.

En outre, l'invention a encore pour objet, selon un autre de ses aspects, l'utilisation :
- d'un module photovoltaïque tel que défini précédemment, en particulier du type comprenant une structure sandwich en face arrière, à savoir dans lequel la deuxième couche comporte une couche arrière formant un panneau arrière en matériau composite, comprenant une sous-couche principale, formant l'âme du panneau arrière, et deux sous-couches de recouvrement, formant chacune une plaque du panneau arrière, disposées de part et d'autre de l'âme de sorte que l'âme soit prise en sandwich entre les deux plaques, l'âme du panneau arrière comportant une structure alvéolaire, et
- d'un support de fixation du module photovoltaïque comprenant au moins deux éléments de support et de fixation, notamment sous la forme de rails, espacés l'un de l'autre, et préférentiellement s'étendant de façon sensiblement parallèle entre eux, caractérisée en ce qu'elle comporte l'étape consistant à positionner le module photovoltaïque au contact seulement desdits au moins deux éléments de support et de fixation et à fixer le module photovoltaïque.

Dans le cas d'un module photovoltaïque comprenant une deuxième couche arrière traditionnelle, de type « backsheet », le module est avantageusement directement collé sur son support, par exemple un support de toiture.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 1A représente une variante de réalisation de l'exemple de la figure 1 dans laquelle les cellules photovoltaïques sont de type IBC,
- la figure 2 représente, en vue éclatée, le module photovoltaïque de la figure 1,
- la figure 3 illustre, en perspective et en vue éclatée, un premier exemple de réalisation d'un module photovoltaïque conforme à l'invention,
- la figure 3A illustre, en coupe, un exemple de couche arrière utilisée pour le module photovoltaïque représenté à la figure 3,
- la figure 3B illustre, selon une vue du dessus, une configuration de test mécanique, en particulier de test de choc grêle selon la norme IEC 61215, d'un module photovoltaïque conforme à l'invention,
- la figure 3C illustre, selon une vue du dessus en perspective, un exemple d'utilisation d'un module photovoltaïque conforme à l'invention,
- la figure 3D illustre, selon une vue du dessus en perspective, un autre exemple d'utilisation d'un module photovoltaïque conforme à l'invention,
- la figure 4 illustre, en perspective et en vue éclatée, un deuxième exemple de réalisation d'un module photovoltaïque conforme à l'invention,
- la figure 5 illustre, en perspective et en vue éclatée, un troisième exemple de réalisation d'un module photovoltaïque conforme à l'invention,
- la figure 6 illustre, en perspective et en vue éclatée, un quatrième exemple de réalisation d'un module photovoltaïque conforme à l'invention,
- la figure 7 est une vue du dessus partielle d'un exemple de module photovoltaïque illustrant le principe d'une couche en verre de dimensions réduites par rapport à celles du module photovoltaïque,
- la figure 8 est une vue du dessus d'un exemple de couche en verre, avant et/ou arrière, comportant des bords arrondis au niveau de ses angles,
- la figure 9A est une vue du dessus partielle d'un exemple de module photovoltaïque comportant une couche en verre pourvue d'un cadre polymère sur son pourtour, et
- la figure 9B est une vue en coupe partielle du module photovoltaïque de la figure 9A.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1, 1A et 2 ont déjà été décrites dans la partie relative à l'état de la technique antérieure.

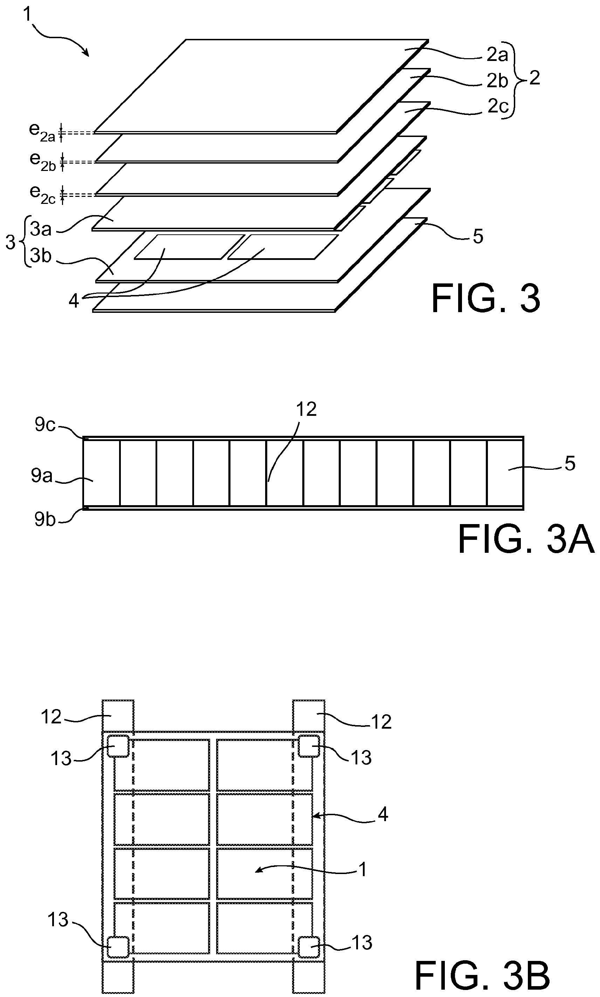

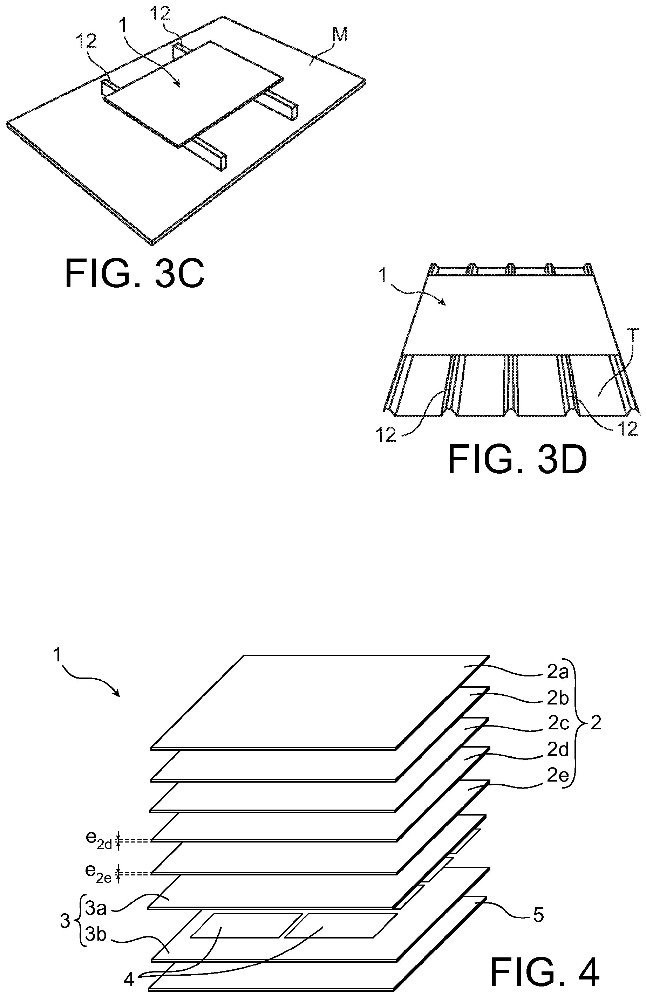

Les figures 3 à 9B permettent d'illustrer quatre modes de réalisation distincts de modules photovoltaïques 1 conformes à l'invention.

On considère ici que les cellules photovoltaïques 4, interconnectées par des rubans en cuivre étamé soudés, semblables à ceux représentés aux figures 1, 1A et 2, sont des cellules « cristallines », c'est-à-dire qu'elles comportent du silicium mono ou multicristallin, et qu'elles présentent une épaisseur comprise entre 1 et 250 µm.

De plus, la couche avant polymère 2a peut être un film polymère fluoré, d'épaisseur de l'ordre de 20 µm, notamment en éthylène chlorotrifluoroéthylène (ECTFE), par exemple de type Amcor^{®} ECTFE 020.

Les couches d'interface 2b, 2d et 5b peuvent comporter un film encapsulant polymère, par exemple de type A formé par un élastomère thermoplastique à base polyoléfine (TPO) ou de type B formé par un copolymère thermoplastique réticulé ioniquement, par exemple de type lonomère. L'épaisseur peut être comprise entre 500 et 600 µm. En particulier, pour un film encapsulant polymère de type B, il peut s'agir du KuranSeal-ES^{®} (PV8729D/UV CUT) de la société Kurabo, d'épaisseur 500 µm.

Les couches en verre 2c, 2e et 5c peuvent comporter un verre mince non trempé d'épaisseur comprise entre 500 et 800 µm, par exemple de l'ordre de 550 µm.

La deuxième couche 5 peut se présenter sous la forme d'une couche ou multicouche polmère de type « backseet » ou encore d'une structure polymérique à base d'un polymère isolant électrique.

La deuxième couche 5 peut encore être sous forme de panneau arrière 5, structure de type « sandwich », et peut comporter une âme 9a en nid d'abeilles en polypropylène et des peaux composites ou plaques 9b, 9c en polypropylène renforcées en verre avec une épaisseur comprise par exemple entre 6 et 10 mm, par exemple de type Nidapan^{®} 8 GR 600 d'épaisseur 10 mm.

Bien entendu, ces choix ne sont nullement limitatifs.

Pour tous les exemples d'empilement décrits en référence aux figures 3 à 9B, des tests ont été effectués vis-à-vis de chocs mécaniques de type grêlons pour des niveaux d'énergie de 2 J représentatifs de la norme de certification IEC 61215. Les résultats ont démontré le fait que l'intégration d'un verre non trempé mince dans le module permet d'obtenir un poids réduit tout en ayant une résistance aux chocs conforme aux normes en vigueur.

En particulier, dans le cas d'une deuxième couche 5 sous la forme d'un panneau arrière 5 de type « sandwich », comme visible sur la figure 3A, les tests de choc mécanique ont été réalisés en suivant la configuration représentée sur la figure 3B. Ainsi, le module photovoltaïque 1, par exemple de dimension 40 cm x 40 cm, a été fixé sur deux rails 12 d'aluminium d'une épaisseur de 4 cm. Cette fixation a été faite par le biais de serre-joints 13. En dehors de la surface de contact entre le module photovoltaïque 1 et les rails 12 d'aluminium, le reste du module 1 n'a reposé sur aucune autre surface.

Les résultats ont démontré l'amélioration accrue de la résistance aux chocs, conforme aux normes en vigueur, avec l'usage d'un verre mince non trempé, de l'ordre de 700 µm, dans un module photovoltaïque 1 dans une configuration de pose discontinue.

Afin de décrire les différentes configurations envisagées, on se réfère tout d'abord à la figure 3 qui illustre, en perspective et en vue éclatée, un premier exemple de réalisation d'un module photovoltaïque 1 conforme à l'invention.

Il est à noter que la figure 3 correspond à une vue éclatée du module photovoltaïque 1 avant l'étape de lamination du procédé selon l'invention. Une fois l'étape de lamination réalisée, assurant un pressage à chaud et sous vide, les différentes couches sont en réalité au contact les unes aux autres, et notamment interpénétrées les unes dans les autres.

Le module photovoltaïque 1, ou plus précisément l'empilement destiné à former le module photovoltaïque 1, comporte ainsi une première couche 2 formant la face avant du module photovoltaïque 1 et destinée à recevoir un flux lumineux, une pluralité de cellules photovoltaïques 4 disposées côte à côte et reliées électriquement entre elles, un ensemble encapsulant 3 la pluralité de cellules photovoltaïques 4, et une deuxième couche 5 formant la face arrière du module photovoltaïque 1.

Il est en outre à noter qu'une boîte de jonction 7 peut être disposée sur la face avant ou encore sur la face arrière, comme représenté sur les figures 1, 1A et 2, du module photovoltaïque 1.

Conformément à l'invention, et de manière commune aux exemples des figures 3 à 6, la première couche 2 comporte une couche avant réalisée en un matériau polymère 2a, dite « couche avant polymère 2a », et un premier ensemble avant 2b, 2c comprenant une couche avant d'interface 2b et une couche avant en verre, avantageusement en verre non trempé 2c.

Avantageusement, la couche avant en verre 2c présente une épaisseur e_{2c} inférieure ou égale à 2 mm, voire inférieure ou égale à 1,5 mm, voire encore comprise entre 500 µm et 1,1 mm, voire encore comprise entre 500 µm et 1 mm, voire encore comprise entre 300 µm et 700 µm, voire encore entre 300 µm et 500 µm,.

Dans cet exemple, la couche avant d'encapsulation 3a, la couche arrière d'encapsulation 3b et la couche avant d'interface 2b sont toutes des films d'encapsulant de type A.

Dans tous les exemples décrits ici en référence aux figures 3 à 6, l'invention peut prévoir avantageusement d'avoir une couche arrière de matériau d'encapsulation avec un module de Young à 25°C strictement supérieur à 150 MPa, notamment strictement supérieure à 200 MPa, préférentiellement strictement supérieur à 200 MPa, voire 150 MPa, et inférieur à 500 MPa, voire encore compris entre 250 et 350 MPa.

La couche avant de matériau d'encapsulation 3a peut être identique à la couche arrière de matériau d'encapsulation 3b selon un mode de réalisation. En variante, elle peut être différente, notamment avec un module de Young à 25°C strictement inférieur à 50 MPa, préférentiellement supérieur à 2 MPa et strictement inférieur à 50 MPa, voire encore compris entre 10 et 20 MPa.

La couche avant de matériau d'encapsulation 3a peut être un film d'encapsulant de type A tandis que la couche arrière de matériau d'encapsulation 3b est un film d'encapsulant de type B. En variante, les couches avant 3a et arrière 3b peuvent être des films d'encapsulant de type B.

Par l'utilisation d'un film d'encapsulant de type B pour la couche arrière de matériau d'encapsulation 3b, plutôt que l'utilisation d'un film encapsulant de type A, on peut ainsi limiter ou complètement éviter tout phénomène de casse du verre et des cellules photovoltaïques 4.

La deuxième couche 5 peut être formée par une face arrière traditionnelle, encore appelée « backsheet » en anglais, comme représenté sur la figure 3. En particulier, la deuxième couche 5 peut être formée par une structure polymérique à base d'un polymère isolant électrique. Elle peut en particulier être réalisée en au moins un matériau polymère, notamment choisi parmi : le polycarbonate (PC), le polyméthacrylate de méthyle (PMMA), le polytéréphtalate d'éthylène (PET), le polypropylène (PP), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres. Dans le cas d'une deuxième couche 5 sous forme de multicouche polymère, une ou plusieurs couches en aluminium peuvent être situées dans le multicouche, étant prise(s) en sandwich dans celui-ci.

La deuxième couche 5 peut encore être sous la forme d'une structure de type « sandwich ». La deuxième couche 5 peut, par exemple, être formée par un panneau arrière 5 en matériau composite, comprenant une sous-couche principale, formant l'âme 9a du panneau arrière 5, et deux sous-couches de recouvrement, formant chacune une plaque 9b, 9c du panneau arrière 5, disposées de part et d'autre de l'âme 9a de sorte que l'âme 9a soit prise en sandwich entre les deux plaques 9b, 9c, l'âme 9a du panneau arrière 5 comportant une structure alvéolaire 12. La figure 3A représente, schématiquement en coupe de façon plus détaillée, une telle deuxième couche 5.

Il est en outre à noter que de façon alternative, la deuxième couche 5 pourrait comporter une couche de renforts à base de fibres, tissées ou non, notamment des fibres de verre, de carbone, d'aramide et/ou des fibres naturelles, notamment de chanvre, de lin et/ou de soie, entre autres.

Le module photovoltaïque 1 est obtenu par le biais d'une seule étape de lamination à chaud sous vide, par exemple à une température d'environ 150°C pendant environ 15 minutes. Il peut présenter un poids surfacique compris entre 4 et 6 kg/cm², par exemple de l'ordre de 6 kg/cm² dans le cas d'une couche 5 de type « backsheet » et de l'ordre de 4 kg/cm² dans le cas d'une couche 5 de type structure sandwich.

Il est également possible d'utiliser des films d'encapsulant de type B pour la couche avant d'encapsulation 3a, la couche arrière d'encapsulation 3b et la couche avant d'interface 2b. Alors, on améliore encore plus la résistance aux chocs du module photovoltaïque 1 du fait d'un module de Young plus élevé.

Dans le cas d'une deuxième couche 5 sous la forme d'une structure sandwich, du type de la figure 3A, les figures 3C et 3D illustrent deux exemples de configurations d'utilisation d'un tel module photovoltaïque 1 conforme à l'invention.

L'utilisation d'un module photovoltaïque 1 conforme à l'invention consiste à positionner le module 1 et à le fixer sur un support de fixation M, T qui comprend une pluralité d'éléments de support et de fixation 12, et notamment des rails 12 parallèles entre eux et définissant des espaces entre eux.

Ainsi, dans l'exemple de la figure 3C, le panneau 5 du module photovoltaïque 1 n'est pas collé directement sur la membrane d'étanchéité M, ce qui entraînerait une absence de séparation entre la surface de la membrane M et le panneau 5. Au contraire, des rails 12 sont positionnés sur la membrane M, en étant espacés l'un de l'autre, et le panneau 5 du module photovoltaïque 1 est fixé directement et uniquement au contact des rails 12.

Par ailleurs, dans l'exemple de la figure 3D, le panneau 5 du module photovoltaïque 1 est fixé sur les nervures ou ondulations, formant des rails 12 parallèles et espacés les uns des autres, d'une tôle T de toiture, par exemple en acier. Par le biais d'un contact unique sur les rails 12 de la tôle T, on évite ainsi le contact à l'humidité et l'encrassement potentiel tout en disposant d'un espace plus grand pour le positionnement du panneau 5. Au contraire, on obtient une flexibilité dans le choix des dimensions du panneau 5 et/ou de la tôle T, un espacement entre la surface de la tôle T et le panneau 5 et une résistance à la grêle liée au principe de l'invention.

L'invention permet ainsi de proposer un module photovoltaïque 1 et une utilisation de celui-ci qui sont particulièrement adaptés pour des applications sensibles à la surcharge, notamment les toitures, tout en conservant une séparation entre le panneau 5 et la surface, notamment la toiture. Pour des toitures quasiment planes de type terrasse, comme pour l'exemple de la figure 3C, ou des toitures inclinées, comme pour l'exemple de la figure 3D, l'invention permet de réduire le contact du module 1 avec la surface de la toiture, et donc une limitation de la pénétration d'humidité ou des phénomènes de gel et dégel, de sorte à le protéger et garantir l'étanchéité. L'utilisation de supports existants ou de supports spécifiques peut être considérée.

Par ailleurs, la figure 4 illustre un deuxième exemple de réalisation conforme à l'invention.

Dans cet exemple, à la différence de celui de la figure 3, la première couche 2 comporte également un deuxième ensemble avant 2d, 2e comprenant une couche avant d'interface 2d et une couche avant en verre, avantageusement en verre non trempé 2e. La couche avant en verre 2e présente une épaisseur e₂ₑ inférieure ou égale à 2 mm, voire inférieure ou égale à 1,5 mm, voire encore comprise entre 500 µm et 1,1 mm, voire encore comprise entre 500 µm et 1 mm, voire encore comprise entre 300 µm et 700 µm, voire encore entre 300 µm et 500 µm,. Autrement dit, cet exemple de réalisation prévoit le doublement de l'épaisseur de verre dans la première couche 2. On obtient alors un module photovoltaïque 1 de poids surfacique égal à 6 kg/cm². La résistance aux chocs du module photovoltaïque 1 est encore plus améliorée.

De plus, la première couche avant d'interface 2b et les couches avant 3a et arrière 3b d'encapsulation sont formées par des films d'encapsulant de type A, alors que la deuxième couche avant d'interface 2d est formé par un film d'encapsulant de type B.

Dans l'exemple de la figure 4, la première couche avant en verre 2b et la deuxième couche avant en verre 2e présentent la même épaisseur. En variante, il est possible d'utiliser des épaisseurs de verre différentes, par exemple une épaisseur e_{2b} de l'ordre de 500 µm et une épaisseur e₂ₑ de l'ordre de 300 µm. Ainsi, si on considère que 800 µm de verre peuvent répondre au besoin de tenue des cellules 4 aux chocs, il est possible d'utiliser par exemple un verre de 500 µm et un verre de 300 µm.

En effet, il est connu que les matériaux élastomères ont des propriétés d'amortissement des vibrations et des chocs. L'alternance de matériaux rigides avec des matériaux élastomères va ainsi permettre de modifier la vitesse de propagation des ondes de choc, du fait que la célérité d'une onde de choc est directement proportionnelle au module de Young et coefficients de Poisson du matériau utilisé. L'insertion de couches élastomères souples, entre des couches de matériaux plus rigides, permet donc de ralentir la propagation des ondes de choc. De plus, à chaque interface rencontrée, l'onde de choc peut être transmise et/ou réfléchie en partie. La répétition de l'alternance de ces couches polymères ayant des modules de Young différents permet donc d'une part le ralentissement des ondes de choc et d'autre part la diminution de l'intensité de ces dernières qui arrivent jusqu'aux cellules photovoltaïques.

Aussi, à quantité de verre équivalente, il peut être plus intéressant de répartir cette quantité entre au moins deux couches de verre d'épaisseurs différentes au lieu d'une seule couche de verre.

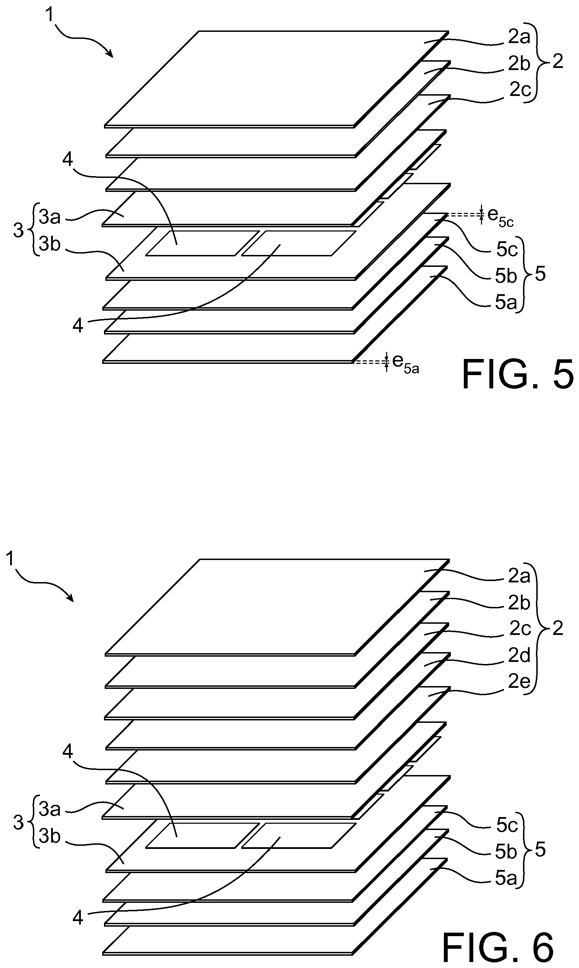

En outre, la figure 5 illustre encore un troisième exemple de réalisation dont le principe est d'utiliser en face arrière la même architecture d'encapsulation qu'en face avant, de manière symétrique. On peut ainsi obtenir un module photovoltaïque 1 bifacial et léger.

Ainsi, la deuxième couche 5 comporte ici une couche arrière réalisée en un matériau polymère 5a, dite « couche arrière polymère 5a », et un premier ensemble arrière 5b, 5c comprenant une couche arrière d'interface 5b et une couche arrière en verre, de préférence non trempé 5c.

La couche arrière en verre 5c présente une épaisseur e_{5c} de 550 µm, et la couche avant en verre 2c présente également une épaisseur e_{2c} de 550 µm.

La couche avant d'interface 2b, la couche arrière d'interface 5b, les couches d'encapsulation avant 3a et arrière 3b sont ici des films d'encapsulant de type B.

Par ailleurs, la figure 6 illustre un quatrième exemple de réalisation correspondant à une variante de l'exemple de la figure 5 dans laquelle l'utilisation de verres minces de préférence non trempés en face avant et en face arrière est réalisée de manière asymétrique.

En particulier, deux verres minces 2c et 2e peuvent être utilisés en face avant d'épaisseurs identiques ou différentes, et un verre mince 5c peut être utilisé en face arrière. Plus précisément ici, une première couche avant en verre 2c présente une épaisseur e_{2c} de 500 µm, une deuxième couche avant en verre 2e présente une épaisseur e₂ₑ de 300 µm, et une première couche arrière en verre 5c présente une épaisseur e_{5c} de 550 µm.

De plus, la première couche avant d'interface 2b, la deuxième couche avant d'interface 2d, la couche arrière d'interface 5b, les couches d'encapsulation avant 3a et arrière 3b sont ici des films d'encapsulant de type B.

Dans tous les exemples décrits précédemment, la couche avant polymère 2a et la couche arrière polymère 5a présentent une épaisseur e₂ₐ, e₅ₐ de l'ordre de 20 µm.

Les couches avant d'interface 2b, 2d et la couche arrière d'interface 5b présentent une épaisseur e_{2b}, e_{2d}, e_{5b} de l'ordre de 600 µm.

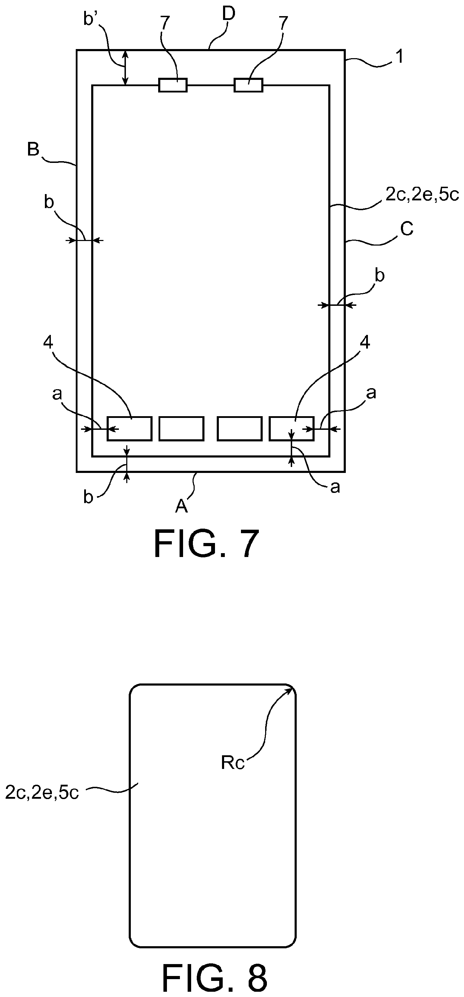

Par ailleurs, on a illustré par le biais des figures 7 à 9B d'autres caractéristiques de l'invention applicables à tous les exemples précédemment décrits.

En particulier, la figure 7 illustre le fait qu'une couche en verre, par exemple une couche avant en verre et/ou une couche arrière en verre, ici la couche avant 2c ou 2e ou la couche arrière 5c, peut présenter des dimensions strictement inférieures aux dimensions de la couche avant polymère 2a et de la deuxième couche 5, et notamment celles du module photovoltaïque 1 obtenu par l'empilement lorsque toutes les couches hormis celles en verre ont les mêmes dimensions, à savoir les mêmes longueurs et mêmes largeurs.

En particulier, la longueur d'une telle couche en verre est strictement inférieure à la longueur du module, et la largeur d'une telle couche en verre est strictement inférieure à la largeur du module. Autrement dit encore, l'aire de la surface d'une telle couche en verre, définie dans un plan transversal à la direction d'empilement, est strictement inférieure à l'aire d'une surface de toute autre couche de l'empilement dans un plan transversal à la direction d'empilement.

Avantageusement, une telle couche en verre se trouve alors encapsulée entre deux couches situées de part et d'autre de celle-ci.

Dans le cas particulier d'un verre non trempé sensible à la casse en cas de choc sur ses bords, le fait d'avoir des dimensions réduites permet ainsi de le protéger des chocs, grâce à l'encapsulation totale de la couche en verre, y compris sur les bords.

La dimension du verre peut être caractérisée par la dimension a représentant la distance entre le bord du dernier élément conducteur et le bord du verre, à savoir ici la distance a entre le bord des cellules 4 et le bord du verre pour les côtés B et C du module, et entre le bord du dernier ruban 6 et le bord du verre pour le côté A du module, opposé aux boîtes de jonction 7. Cette distance a peut être comprise entre 0 et 15 mm, et de préférence de l'ordre de 5 mm.

Par ailleurs, la distance b séparant un bord de la couche en verre et un bord de la couche avant polymère 2a ou la deuxième couche 5, notamment du module photovoltaïque 1 lorsque toutes les couches, hormis celle en verre, ont les mêmes dimensions, peut être strictement supérieure à 1 mm, et cela sur les quatre bords A, B, C et D du module photovoltaïque 1.

En outre, pour le côté D du module où les boîtes de jonction 7 sont présentes, la couche de verre est partiellement disposée sous les boîtes de jonction 7. Le recouvrement peut être compris entre 1 et 30 mm, de préférence entre 1 et 10 mm.

La distance b' séparant le bord de la couche en verre 2c, 2e, 5c et le bord de la couche avant polymère 2a ou la deuxième couche 5, notamment du module photovoltaïque 1 lorsque toutes les couches, hormis celle en verre, ont les mêmes dimensions, peut être d'au moins 5 mm, préférentiellement entre 25 mm et 50 mm, voire de l'ordre de 37 mm.

Par ailleurs, la figure 8 illustre la possibilité pour une couche en verre d'avoir des bords arrondis au niveau des angles, notamment quatre bords arrondis au niveau des quatre angles d'une couche de forme carrée ou rectangulaire.

En effet, en mécanique, des angles droits constituent des concentrations de contraintes et sont donc très fragiles, d'autant plus en cas de verre non trempé. L'arrondi des angles peut ainsi permettre de diminuer les contraintes subies au niveau des angles. Le rayon de courbure Rc peut être strictement supérieur à 1 mm, de préférence à 5 mm. Le rayon de courbure peut en outre être strictement inférieur à 25 mm.

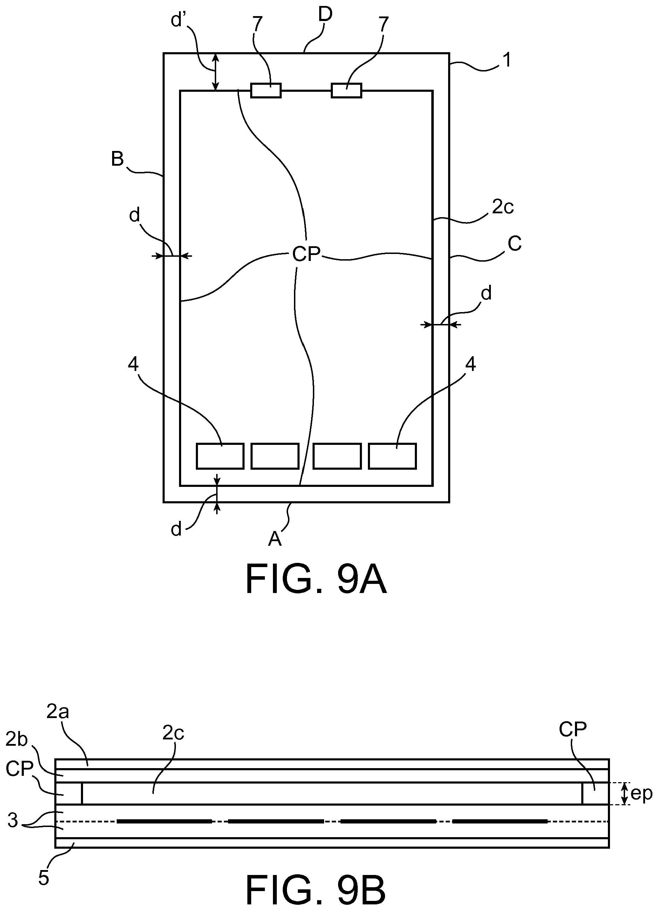

En outre, les figures 9A et 9B illustrent le principe d'ajout d'un cadre polymère au niveau d'une ou plusieurs couches en verre afin de conférer de la rigidité au module, lequel est dépourvu d'un cadre aluminium classique.

En effet, afin d'apporter de la rigidité mécanique sur les bords et faciliter la manutention, l'empilement peut comporter un cadre en polymère CP positionné tout autour de la périphérie d'une couche avant en verre et/ou d'une couche arrière en verre.

Un tel cadre polymère CP peut être ajouté lors de la fabrication du module, positionné au contact d'une couche en verre dans un même plan.

La largeur d du cadre polymère CP peut être comprise entre 1 mm et 30 mm, préférentiellement entre 10 mm et 25 mm, sur les bords A, B et C du module 1. Sur le bord D du côté des boîtes de jonction 7, la largeur d du cadre polymère CP peut être comprise entre 1 mm et 50 mm, préférentiellement entre 30 mm et 40 mm.

Avantageusement, l'épaisseur ep du cadre polymère CP, avant le procédé de lamination, est comprise entre 0,1 mm et 2 mm, préférentiellement entre 0,5 mm et 1 mm. Les propriétés thermomécaniques de ce cadre polymère CP peuvent être identiques à celles d'une des couches de matériau d'encapsulation, par exemple la couche arrière 3b de matériau d'encapsulation ou une des couches d'interface.

Bien entendu, l'invention n'est pas limitée aux exemples de réalisation qui viennent d'être décrits. Diverses modifications peuvent y être apportées par l'homme du métier.

En particulier, ces exemples de réalisation peuvent être déclinés selon diverses variantes en utilisant un ou plusieurs des matériaux mentionnés précédemment pour former la première couche 2 et la deuxième couche 5.

## Revendications

1. Module photovoltaïque (1) obtenu à partir d'un empilement comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches,
**caractérisé en ce que** la première couche (2) comporte :
- une couche avant réalisée en au moins un matériau polymère (2a), dite « couche avant polymère (2a) », et
- au moins un ensemble avant (2b, 2c ; 2d, 2e) comprenant une couche avant d'interface (2b ; 2d) et une couche avant en verre (2c ; 2e), la couche avant en verre (2c ; 2e) présentant une épaisseur (e_{2c} ; e₂ₑ) inférieure ou égale à 2 mm,
ledit au moins un ensemble avant (2b, 2c ; 2d, 2e) étant situé entre la couche avant polymère (2a) et l'ensemble encapsulant (3), et la couche avant d'interface (2b ; 2d) dudit au moins un ensemble avant (2b, 2c ; 2d, 2e) étant située entre la couche avant polymère (2a) et la couche avant en verre (2c ; 2e),
**caractérisé en ce que** la couche avant en verre (2c ; 2e) présente des bords arrondis au niveau de ses angles.

2. Module selon la revendication 1, **caractérisé en ce que** la couche avant en verre (2c ; 2e) présente des dimensions strictement inférieures à celles de la couche avant en au moins un matériau polymère (2a) et celles de la deuxième couche (5), la distance (b, b') séparant un bord de la couche avant en verre (2c ; 2e) et un bord de la couche avant en au moins un matériau polymère (2a) ou un bord de la deuxième couche (5) étant strictement supérieure à 1 mm

3. Module selon la revendication 1 ou 2, **caractérisé en ce que** la couche avant en verre (2c ; 2e) est réalisée en verre non trempé.

4. Module selon l'une des revendications précédentes, **caractérisé en ce que** la distance (a) entre un bord de la couche avant en verre (2c ; 2e) et un bord d'une cellule photovoltaïque (4) et/ou un bord d'un conducteur de liaison (6) reliant des cellules photovoltaïques (4), adjacent au bord de la couche avant en verre (2c ; 2e), est comprise entre 0 et 15 mm, de préférence de l'ordre de 5 mm.

5. Module selon l'une quelconque des revendications précédentes, **caractérisé en ce qu'**il comporte un cadre polymère (CP) disposé tout autour du pourtour de la couche avant en verre (2c ; 2e), le cadre polymère (CP) présentant notamment une largeur (d, d') comprise entre 5 mm et 50 mm, préférentiellement entre 20 mm et 40 mm.

6. Module selon l'une quelconque des revendications précédentes, **caractérisé en ce que** la couche avant en verre (2c ; 2e) présente des bords arrondis au niveau de ses angles avec un rayon de courbure (Rc) strictement supérieur à 1 mm, de préférence strictement inférieur à 25 mm.

7. Module selon l'une quelconque des revendications précédentes, **caractérisé en ce que** la couche avant en verre (2c ; 2e) présente une épaisseur (e_{2c} ; e₂ₑ) inférieure ou égale à 1,5 mm, notamment comprise entre 500 µm et 1,1 mm, notamment encore comprise entre 500 µm et 1 mm, notamment encore comprise entre 300 µm et 700 µm, notamment encore entre 300 µm et 500 µm,.

8. Module selon l'une quelconque des revendications précédentes, **caractérisé en ce que** la deuxième couche (5) est formée par une structure polymérique à base d'un polymère isolant électrique.

9. Module selon l'une quelconque des revendications précédentes, **caractérisé en ce que** la deuxième couche (5) comporte :
- une couche arrière formant un panneau arrière (5) en matériau composite, comprenant une sous-couche principale, formant l'âme (9a) du panneau arrière (5), et deux sous-couches de recouvrement, formant chacune une plaque (9b, 9c) du panneau arrière (5), disposées de part et d'autre de l'âme (9a) de sorte que l'âme (9a) soit prise en sandwich entre les deux plaques (9b, 9c), l'âme (9a) du panneau arrière (5) comportant une structure alvéolaire (12).

10. Module selon l'une quelconque des revendications 1 à 7, **caractérisé en ce que** la deuxième couche (5) comporte :
- une couche arrière réalisée en au moins un matériau polymère (5a), dite « couche arrière polymère (5a) », et
- au moins un ensemble arrière (5b, 5c) comprenant une couche arrière d'interface (5b) et une couche arrière en verre (5c), la couche arrière en verre (5c) présentant notamment une épaisseur (e_{5c}) inférieure ou égale à 2 mm, notamment inférieure ou égale à 1,5 mm, notamment comprise entre 500 µm et 1,1 mm, notamment encore comprise entre 500 µm et 1 mm, notamment encore comprise entre 300 µm et 700 µm, notamment encore entre 300 µm et 500 µm, étant notamment réalisée en verre non trempé, et présentant notamment des dimensions strictement inférieures à celles de la couche arrière polymère (5a) et notamment les mêmes dimensions et caractéristiques que celles de la couche avant en verre (2c),
ledit au moins un ensemble arrière (5b, 5c) étant situé entre la couche arrière polymère (5a) et l'ensemble encapsulant (3), et la couche arrière d'interface (5b) dudit au moins un ensemble arrière (5b, 5c) étant située entre la couche arrière polymère (5a) et la couche arrière en verre (5c).

11. Module selon l'une quelconque des revendications 1 à 7, **caractérisé en ce que** la deuxième couche (5) comporte une couche de renforts à base de fibres, notamment des fibres de verre, de carbone, d'aramide et/ou des fibres naturelles, notamment de chanvre, de lin et/ou de soie.

12. Module selon l'une quelconque des revendications précédentes, **caractérisé en ce que** la couche avant polymère (2a) et/ou la couche arrière polymère (5a) présentent une épaisseur (e₂ₐ, e₅ₐ) comprise entre 15 µm et 300 µm, notamment entre 20 µm et 50 µm.

13. Module selon l'une quelconque des revendications précédentes, **caractérisé en ce que** la couche avant d'interface (2b ; 2d) et/ou la couche arrière d'interface (5b) présentent une épaisseur (e_{2b}, e_{2d} ; e_{5b}) comprise entre 50 µm et 600 µm, notamment entre 400 µm et 600 µm, notamment entre 400 µm et 500 µm.

14. Module selon l'une quelconque des revendications précédentes, **caractérisé en ce que** le matériau polymère de la couche avant polymère (2a) et/ou de la couche arrière polymère (5a) est choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités.

15. Module selon l'une quelconque des revendications précédentes, **caractérisé en ce que** l'ensemble encapsulant (3), la couche avant d'interface (2b ; 2d) et/ou l'éventuelle couche arrière d'interface (5b) sont formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

16. Module selon l'une quelconque des revendications précédentes, **caractérisé en ce que** la première couche (2) comporte :
- un premier ensemble avant (2b, 2c) comprenant une couche avant d'interface (2b) et une couche avant en verre (2c), la couche avant en verre (2c) présentant une épaisseur (e_{2c}) inférieure ou égale à 2 mm,
- un deuxième ensemble avant (2d, 2e) comprenant une couche avant d'interface (2d) et une couche avant en verre (2e), la couche avant en verre (2e) présentant une épaisseur (e₂ₑ) inférieure ou égale à 2 mm,
le premier ensemble avant (2b, 2c) étant situé entre la couche avant polymère (2a) et le deuxième ensemble avant (2d, 2e), lui-même situé entre le premier ensemble avant (2b, 2c) et l'ensemble encapsulant (3).

17. Module selon la revendication 16, **caractérisé en ce que** l'épaisseur (e_{2c}) de la couche avant en verre (2c) du premier ensemble avant (2b, 2c) et l'épaisseur (e₂ₑ) de la couche avant en verre (2e) du deuxième ensemble avant (2d, 2e) sont différentes.

18. Module selon la revendication 17, **caractérisé en ce que** l'épaisseur (e_{2c}) de la couche avant en verre (2c) du premier ensemble avant (2b, 2c) est supérieure à l'épaisseur (e₂ₑ) de la couche avant en verre (2e) du deuxième ensemble avant (2d, 2e).

19. Module selon l'une quelconque des revendications précédentes, **caractérisé en ce que** la deuxième couche (5) comporte :
- une couche arrière réalisée en au moins un matériau polymère (5a), dite « couche arrière polymère (5a) », et
- un premier ensemble arrière (5b, 5c) comprenant une couche arrière d'interface (5b) et une couche arrière en verre (5c), la couche arrière en verre (5c) présentant notamment une épaisseur (e_{5c}) inférieure ou égale à 2 mm, notamment inférieure ou égale à 1,5 mm, notamment comprise entre 500 µm et 1,1 mm, notamment encore comprise entre 500 µm et 1 mm, notamment encore comprise entre 300 µm et 700 µm, notamment encore entre 300 µm et 500 µm, et étant notamment réalisée en verre non trempé,
- un deuxième ensemble arrière comprenant une couche arrière d'interface et une couche arrière en verre, la couche arrière en verre présentant notamment une épaisseur inférieure ou égale à 2 mm, notamment inférieure ou égale à 1,5 mm, notamment comprise entre 500 µm et 1,1 mm, notamment encore comprise entre 500 µm et 1 mm, notamment encore comprise entre 300 µm et 700 µm, notamment encore entre 300 µm et 500 µm, et étant notamment réalisée en verre non trempé,
ledit premier ensemble arrière (5b, 5c) étant situé entre la couche arrière polymère (5a) et le deuxième ensemble arrière, lui-même situé entre le premier ensemble arrière (5b, 5c) et l'ensemble encapsulant (3).

20. Procédé de réalisation d'un module photovoltaïque (1) selon l'une quelconque des revendications précédentes, à partir d'un empilement comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5), l'ensemble encapsulant (3) et la pluralité de cellules photovoltaïques (4) étant situés entre les première (2) et deuxième (5) couches, **caractérisé en ce que** la première couche (2) comporte :
- une couche avant réalisée en au moins un matériau polymère (2a), dite « couche avant polymère (2a) », et
- au moins un ensemble avant (2b, 2c ; 2d, 2e) comprenant une couche avant d'interface (2b ; 2d) et une couche avant en verre (2c ; 2e), la couche avant en verre (2c ; 2e) présentant une épaisseur (e_{2c} ; e₂ₑ) inférieure ou égale à 2 mm,
ledit au moins un ensemble avant (2b, 2c ; 2d, 2e) étant situé entre la couche avant polymère (2a) et l'ensemble encapsulant (3), et la couche avant d'interface (2b ; 2d) dudit au moins un ensemble avant (2b, 2c ; 2d, 2e) étant située entre la couche avant polymère (2a) et la couche avant en verre (2c ; 2e),
**caractérisé en ce que** la couche avant en verre (2c ; 2e) présente des bords arrondis au niveau de ses angles.

## Patentansprüche

1. Photovoltaikmodul (1), erhalten aus einem Stapel, aufweisend:
- eine erste transparente Schicht (2), die die Vorderseite des Photovoltaikmoduls (1) bildet, die dazu bestimmt ist, einen Lichtstrom zu empfangen,
- eine Vielzahl von Photovoltaikzellen (4), die nebeneinander angeordnet und elektrisch miteinander verbunden sind,
- eine Anordnung (3), die die Vielzahl von Photovoltaikzellen (4) umschließt,
- eine zweite Schicht (5), die die Rückseite des Photovoltaikmoduls (1) bildet, wobei sich die umschließende Anordnung (3) und die Vielzahl von Photovoltaikzellen (4) zwischen der ersten (2) und zweiten (5) Schicht befinden,
**dadurch gekennzeichnet, dass** die erste Schicht (2) aufweist:
- eine vordere Schicht, die aus mindestens einem Polymermaterial (2a) hergestellt ist, bezeichnet als "vordere Polymerschicht (2a)", und
- mindestens eine vordere Anordnung (2b, 2c; 2d, 2e), die eine vordere Zwischenschicht (2b; 2d) und eine vordere Glasschicht (2c; 2e) umfasst, wobei die vordere Glasschicht (2c; 2e) eine Dicke (e_{2c}; e₂ₑ) kleiner oder gleich 2 mm aufweist,
wobei sich die mindestens eine vordere Anordnung (2b, 2c; 2d, 2e) zwischen der vorderen Polymerschicht (2a) und der umschließenden Anordnung (3) befindet und sich die vordere Zwischenschicht (2b; 2d) der mindestens einen vorderen Anordnung (2b, 2c; 2d, 2e) zwischen der vorderen Polymerschicht (2a) und der vorderen Glasschicht (2c; 2e) befindet,
**dadurch gekennzeichnet, dass** die vordere Glasschicht (2c; 2e) an ihren Ecken abgerundete Kanten aufweist.

2. Modul nach Anspruch 1, **dadurch gekennzeichnet, dass** die vordere Glasschicht (2c; 2e) Abmessungen aufweist, die strikt kleiner als die der vorderen Schicht aus mindestens einem Polymermaterial (2a) und die der zweiten Schicht (5) sind, wobei der Abstand (b, b'), der eine Kante der vorderen Glasschicht (2c; 2e) und eine Kante der vorderen Schicht aus mindestens einem Polymermaterial (2a) oder eine Kante der zweiten Schicht (5) trennt, strikt größer als 1 mm ist.

3. Modul nach Anspruch 1 oder 2, **dadurch gekennzeichnet, dass** die vordere Glasschicht (2c; 2e) aus nicht gehärtetem Glas hergestellt ist.

4. Modul nach einem der vorhergehenden Ansprüche, **dadurch gekennzeichnet, dass** der Abstand (a) zwischen einer Kante der vorderen Glasschicht (2c; 2e) und einer Kante einer Photovoltaikzelle (4) und/oder einer Kante eines Verbindungsleiters (6), der Photovoltaikzellen (4) verbindet, der an die Kante der vorderen Glasschicht (2c; 2e) angrenzt, zwischen 0 und 15 mm, vorzugsweise in der Größenordnung von 5 mm, liegt.

5. Modul nach einem der vorhergehenden Ansprüche, **dadurch gekennzeichnet, dass** es einen Polymerrahmen (CP) aufweist, der um den gesamten Umfang der vorderen Glasschicht (2c; 2e) angeordnet ist, wobei der Polymerrahmen (CP) insbesondere eine Breite (d, d') zwischen 5 mm und 50 mm, vorzugsweise zwischen 20 mm und 40 mm, aufweist.

6. Modul nach einem der vorhergehenden Ansprüche, **dadurch gekennzeichnet, dass** die vordere Glasschicht (2c; 2e) an ihren Ecken abgerundete Kanten mit einem Krümmungsradius (Rc) strikt größer als 1 mm, vorzugsweise strikt kleiner als 25 mm, aufweist.

7. Modul nach einem der vorhergehenden Ansprüche, **dadurch gekennzeichnet, dass** die vordere Glasschicht (2c; 2e) eine Dicke (e_{2c}; e₂ₑ) kleiner oder gleich 1,5 mm, insbesondere zwischen 500 µm und 1,1 mm, insbesondere auch zwischen 500 µm und 1 mm, insbesondere auch zwischen 300 µm und 700 µm, insbesondere auch zwischen 300 µm und 500 µm, aufweist.

8. Modul nach einem der vorhergehenden Ansprüche, **dadurch gekennzeichnet, dass** die zweite Schicht (5) von einer Polymerstruktur auf Basis eines elektrisch isolierenden Polymers gebildet ist.

9. Modul nach einem der vorhergehenden Ansprüche, **dadurch gekennzeichnet, dass** die zweite Schicht (5) aufweist:
- eine hintere Schicht, die ein hinteres Paneel (5) aus Verbundwerkstoff bildet, umfassend eine Hauptunterschicht, die den Kern (9a) des hinteren Paneels (5) bildet, und zwei Deckunterschichten, die jeweils eine Platte (9b, 9c) des hinteren Paneels (5) bilden, die auf beiden Seiten des Kerns (9a) so angeordnet sind, dass der Kern (9a) zwischen den beiden Platten (9b, 9c) sandwichartig eingeschlossen ist, wobei der Kern (9a) des hinteren Paneels (5) eine Wabenstruktur (12) aufweist.

10. Modul nach einem der Ansprüche 1 bis 7, **dadurch gekennzeichnet, dass** die zweite Schicht (5) aufweist:
- eine hintere Schicht, die aus mindestens einem Polymermaterial (5a) hergestellt ist, bezeichnet als "hintere Polymerschicht (5a)", und
- mindestens eine hintere Anordnung (5b, 5c), die eine hintere Zwischenschicht (5b) und eine hintere Glasschicht (5c) umfasst, wobei die hintere Glasschicht (5c) insbesondere eine Dicke (e_{5c}) kleiner oder gleich 2 mm, insbesondere kleiner oder gleich 1,5 mm, insbesondere zwischen 500 µm und 1,1 mm, insbesondere auch zwischen 500 µm und 1 mm, insbesondere auch zwischen 300 µm und 700 µm, insbesondere auch zwischen 300 µm und 500 µm, aufweist, insbesondere aus nicht gehärtetem Glas hergestellt ist und insbesondere Abmessungen, die strikt kleiner als die der hinteren Polymerschicht (5a) sind und insbesondere die gleichen Abmessungen und Merkmale wie die der vorderen Glasschicht (2c) aufweist,
wobei sich die mindestens eine hintere Anordnung (5b, 5c) zwischen der hinteren Polymerschicht (5a) und der umschließenden Anordnung (3) befindet und sich die hintere Zwischenschicht (5b) der mindestens einen hinteren Anordnung (5b, 5c) zwischen der hinteren Polymerschicht (5a) und der hinteren Glasschicht (5c) befindet.

11. Modul nach einem der Ansprüche 1 bis 7, **dadurch gekennzeichnet, dass** die zweite Schicht (5) eine Schicht aus faserbasierten Verstärkungen, insbesondere Glas-, Kohlenstoff-, Aramidfasern und/oder Naturfasern, insbesondere Hanf, Flachs und/oder Seide, aufweist.

12. Modul nach einem der vorhergehenden Ansprüche, **dadurch gekennzeichnet, dass** die vordere Polymerschicht (2a) und/oder die hintere Polymerschicht (5a) eine Dicke (e₂ₐ, e₅ₐ) zwischen 15 µm und 300 µm, insbesondere zwischen 20 µm und 50 µm, aufweisen.

13. Modul nach einem der vorhergehenden Ansprüche, **dadurch gekennzeichnet, dass** die vordere Zwischenschicht (2b; 2d) und/oder die hintere Zwischenschicht (5b) eine Dicke (e_{2b}, e_{2d}; e_{5b}) zwischen 50 µm und 600 µm, insbesondere zwischen 400 µm und 600 µm, insbesondere zwischen 400 µm und 500 µm, aufweisen.

14. Modul nach einem der vorhergehenden Ansprüche, **dadurch gekennzeichnet, dass** das Polymermaterial der vorderen Polymerschicht (2a) und/oder der hinteren Polymerschicht (5a) ausgewählt ist aus: Polycarbonat (PC), Polymethylmethacrylat (PMMA), Polyethylenterephthalat (PET), Polyamid (PA), einem fluorierten Polymer, insbesondere Polyvinylfluorid (PVF) oder Polyvinylidenfluorid (PVDF), Ethylentetrafluorethylen (ETFE), Ethylenchlortrifluorethylen (ECTFE), Polytetrafluorethylen (PTFE), Polychlortrifluorethylen (PCTFE), fluoriertem Ethylenpropylen (FEP) und/oder einer Mehrschichtfolie, die eins oder mehrere der vorgenannten Polymere umfasst.

15. Modul nach einem der vorhergehenden Ansprüche, **dadurch gekennzeichnet, dass** die umschließende Anordnung (3), die vordere Zwischenschicht (2b; 2d) und/oder die eventuelle hintere Zwischenschicht (5b) aus mindestens einer Schicht gebildet sind, die mindestens ein polymerartiges umschließendes Material aufweist, das ausgewählt ist aus: Säurecopolymeren, Ionomeren, Poly(ethylen-vinylacetat) (EVA), Vinylacetalen, wie beispielsweise Polyvinylbutyralen (PVB), Polyurethanen, Polyvinylchloriden, Polyethylenen, wie beispielsweise linearen Polyethylenen niedriger Dichte, Polyolefin-Elastomer-Copolymeren, α-Olefin-Copolymeren und α-, β-Estern von Carbon- bis Ethylensäure, wie beispielsweise Ethylen-Methylacrylat-Copolymere und Ethylen-Butylacrylat-Copolymere, Silikon-Elastomere und/oder Elastomere auf Basis von vernetztem thermoplastischem Polyolefin.

16. Modul nach einem der vorhergehenden Ansprüche, **dadurch gekennzeichnet, dass** die erste Schicht (2) aufweist:
- eine erste vordere Anordnung (2b, 2c), die eine vordere Zwischenschicht (2b) und eine vordere Glasschicht (2c) umfasst, wobei die vordere Glasschicht (2c) eine Dicke (e_{2c}) kleiner oder gleich 2 mm aufweist,
- eine zweite vordere Anordnung (2d, 2e), die eine vordere Zwischenschicht (2d) und eine vordere Glasschicht (2e) aufweist, wobei die vordere Glasschicht (2e) eine Dicke (e₂ₑ) kleiner oder gleich 2 mm aufweist,
wobei sich die erste vordere Anordnung (2b, 2c) zwischen der vorderen Polymerschicht (2a) und der zweiten vorderen Anordnung (2d, 2e) befindet, die sich ihrerseits zwischen der ersten vorderen Anordnung (2b, 2c) und der umschließenden Anordnung (3) befindet.

17. Modul nach Anspruch 16, **dadurch gekennzeichnet, dass** die Dicke (e_{2c}) der vorderen Glasschicht (2c) der ersten vorderen Anordnung (2b, 2c) und die Dicke (e₂ₑ) der vorderen Glasschicht (2e) der zweiten vorderen Anordnung (2d, 2e) unterschiedlich sind.

18. Modul nach Anspruch 17, **dadurch gekennzeichnet, dass** die Dicke (e_{2c}) der vorderen Glasschicht (2c) der ersten vorderen Anordnung (2b, 2c) größer als die Dicke (e₂ₑ) der vorderen Glasschicht (2e) der zweiten vorderen Anordnung (2d, 2e) ist.

19. Modul nach einem der vorhergehenden Ansprüche, **dadurch gekennzeichnet, dass** die zweite Schicht (5) aufweist:
- eine hintere Schicht, die aus mindestens einem Polymermaterial (5a) hergestellt ist, bezeichnet als "hintere Polymerschicht (5a)", und
- eine erste hintere Anordnung (5b, 5c), die eine hintere Zwischenschicht (5b) und eine hintere Glasschicht (5c) umfasst, wobei die hintere Glasschicht (5c) insbesondere eine Dicke (e_{5c}) kleiner oder gleich 2 mm, insbesondere kleiner oder gleich 1,5 mm, insbesondere zwischen 500 µm und 1,1 mm, insbesondere auch zwischen 500 µm und 1 mm, insbesondere auch zwischen 300 µm und 700 µm, insbesondere auch zwischen 300 µm und 500 µm, aufweist, und insbesondere aus nicht gehärtetem Glas hergestellt ist,
- eine zweite hintere Anordnung, die eine hintere Zwischenschicht und eine hintere Glasschicht umfasst, wobei die hintere Glasschicht insbesondere eine Dicke kleiner oder gleich 2 mm, insbesondere kleiner oder gleich 1,5 mm, insbesondere zwischen 500 µm und 1,1 mm, insbesondere auch zwischen 500 µm und 1 mm, insbesondere auch zwischen 300 µm und 700 µm, insbesondere auch zwischen 300 µm und 500 µm, aufweist, und insbesondere aus nicht gehärtetem Glas hergestellt ist,
wobei sich die erste hintere Anordnung (5b, 5c) zwischen der hinteren Polymerschicht (5a) und der zweiten hinteren Anordnung befindet, die sich ihrerseits zwischen der ersten hinteren Anordnung (5b, 5c) und der umschließenden Anordnung (3) befindet.

20. Verfahren zur Herstellung eines Photovoltaikmoduls (1) nach einem der vorhergehenden Ansprüche aus einem Stapel, aufweisend:
- eine erste transparente Schicht (2), die die Vorderseite des Photovoltaikmoduls (1) bildet, die dazu bestimmt ist, einen Lichtstrom zu empfangen,
- eine Vielzahl von Photovoltaikzellen (4), die nebeneinander angeordnet und elektrisch miteinander verbunden sind,
- eine Anordnung (3), die die Vielzahl von Photovoltaikzellen (4) umschließt,
- eine zweite Schicht (5), wobei sich die umschließende Anordnung (3) und die Vielzahl von Photovoltaikzellen (4) zwischen der ersten (2) und zweiten (5) Schicht befinden,
**dadurch gekennzeichnet, dass** die erste Schicht (2) aufweist:
- eine vordere Schicht, die aus mindestens einem Polymermaterial (2a) hergestellt ist, bezeichnet als "vordere Polymerschicht (2a)", und
- mindestens eine vordere Anordnung (2b, 2c; 2d, 2e), die eine vordere Zwischenschicht (2b; 2d) und eine vordere Glasschicht (2c; 2e) umfasst, wobei die vordere Glasschicht (2c; 2e) eine Dicke (e_{2c}; e₂ₑ) kleiner oder gleich 2 mm aufweist,
wobei sich die mindestens eine vordere Anordnung (2b, 2c; 2d, 2e) zwischen der vorderen Polymerschicht (2a) und der umschließenden Anordnung (3) befindet und sich die vordere Zwischenschicht (2b; 2d) der mindestens einen vorderen Anordnung (2b, 2c; 2d, 2e) zwischen der vorderen Polymerschicht und der vorderen Glasschicht (2c; 2e) befindet,
**dadurch gekennzeichnet, dass** die vordere Glasschicht (2c; 2e) an ihren Ecken abgerundete Kanten aufweist.

## Claims

1. A photovoltaic module (1) formed from a stack comprising:
- a first transparent layer (2) forming the front face of the photovoltaic module (1), designed to receive a light flux,
- a plurality of photovoltaic cells (4) arranged side by side and electrically connected to one another,
- an assembly (3) encapsulating the plurality of photovoltaic cells (4),
- a second layer (5) forming the rear face of the photovoltaic module (1), the encapsulating assembly (3) and the plurality of photovoltaic cells (4) being situated between the first (2) and second (5) layers,
**characterised in that** the first layer (2) comprises:
- a front layer made of at least one polymeric material (2a), referred to as the "polymeric front layer (2a)", and
- at least one front assembly (2b, 2c; 2d, 2e) comprising a front interface layer (2b; 2d) and a front glass layer (2c; 2e), the front glass layer (2c; 2e) having a thickness (e_{2c} ; e₂ₑ) of 2 mm or less,
said at least one front assembly (2b, 2c; 2d, 2e) being situated between the front polymer layer (2a) and the encapsulating assembly (3), and the front interface layer (2b; 2d) of said at least one front assembly (2b, 2c; 2d, 2e) being situated between the front polymer layer (2a) and the front glass layer (2c; 2e),
**characterised in that** the front glass layer (2c; 2e) has rounded edges at its corners.

2. A module according to claim 1, **characterised in that** the front glass layer (2c; 2e) has dimensions strictly smaller than those of the front layer made of at least one polymeric material (2a) and those of the second layer (5), the distance (b, b') between an edge of the front glass layer (2c; 2e) and an edge of the front layer (2a) made of at least one polymeric material or an edge of the second layer (5) being strictly greater than 1 mm

3. A module according to claim 1 or 2, **characterised in that** the front glass layer (2c; 2e) is made of non-tempered glass.

4. A module according to one of the preceding claims, **characterised in that** the distance (a) between an edge of the front glass layer (2c; 2e) and an edge of a photovoltaic cell (4) and/or an edge of a connecting conductor (6) connecting photovoltaic cells (4), adjacent to the edge of the front glass layer (2c; 2e), is between 0 and 15 mm, preferably in the region of 5 mm.

5. A module according to any one of the preceding claims, **characterised in that** it comprises a polymer frame (CP) arranged all around the periphery of the front glass layer (2c; 2e), the polymer frame (CP) having, in particular, a width (d, d') of between 5 mm and 50 mm, preferably between 20 mm and 40 mm.

6. A module according to any one of the preceding claims, **characterised in that** the front glass layer (2c; 2e) has rounded edges at its corners with a radius of curvature (Rc) strictly greater than 1 mm, preferably strictly less than 25 mm.

7. A module according to any one of the preceding claims, **characterised in that** the front glass layer (2c; 2e) has a thickness (e_{2c} ; e₂ₑ ) of less than or equal to 1.5 mm, in particular between 500 µm and 1.1 mm, in particular further between 500 µm and 1 mm, in particular further between 300 µm and 700 µm, in particular further between 300 µm and 500 µm.

8. A module according to any one of the preceding claims, **characterised in that** the second layer (5) is formed by a polymeric structure based on an electrically insulating polymer.

9. A module according to any one of the preceding claims, **characterised in that** the second layer (5) comprises:
- a rear layer forming a rear panel (5) made of composite material, comprising a main sub-layer, forming the core (9a) of the rear panel (5), and two covering sub-layers, each forming a plate (9b, 9c) of the rear panel (5), arranged on either side of the core (9a) so that the core (9a) is sandwiched between the two plates (9b, 9c), the core (9a) of the rear panel (5) comprising a honeycomb structure (12).

10. A module according to any one of claims 1 to 7, **characterised in that** the second layer (5) comprises:
- a rear layer made of at least one polymeric material (5a), referred to as the "polymeric rear layer (5a)", and
- at least one rear assembly (5b, 5c) comprising a rear interface layer (5b) and a rear glass layer (5c), the rear glass layer (5c) having, in particular, a thickness (e_{5c}) of 2 mm or less, in particular 1.5 mm or less, in particular between 500 µm and 1.1 mm, in particular between 500 µm and 1 mm, in particular further between 300 µm and 700 µm, in particular further between 300 µm and 500 µm, being in particular made of non-tempered glass, and having in particular dimensions strictly smaller than those of the polymeric rear layer (5a) and in particular the same dimensions and characteristics as those of the front glass layer (2c),
said at least one rear assembly (5b, 5c) being situated between the polymer rear layer (5a) and the encapsulating assembly (3), and the rear interface layer (5b) of said at least one rear assembly (5b, 5c) being situated between the polymer rear layer (5a) and the glass rear layer (5c).

11. A module according to any one of claims 1 to 7, **characterised in that** the second layer (5) comprises a reinforcing layer based on fibres, in particular glass fibres, carbon fibres, aramid fibres and/or natural fibres, in particular hemp, flax and/or silk.

12. A module according to any one of the preceding claims, **characterised in that** the front polymer layer (2a) and/or the rear polymer layer (5a) have a thickness (e₂ₐ, e₅ₐ) of between 15 µm and 300 µm, in particular between 20 µm and 50 µm.

13. A module according to any one of the preceding claims, **characterised in that** the front interface layer (2b; 2d) and/or the rear interface layer (5b) have a thickness (e_{2b} , e_{2d} ; e_{5b} ) of between 50 µm and 600 µm, in particular between 400 µm and 600 µm, in particular between 400 µm and 500 µm.

14. A module according to any one of the preceding claims, **characterised in that** the polymeric material of the front polymeric layer (2a) and/or the rear polymeric layer (5a) is selected from: polycarbonate (PC), polymethyl methacrylate (PMMA), polyethylene terephthalate (PET), polyamide (PA), a fluorinated polymer, in particular polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE), polychlorotrifluoroethylene (PCTFE), fluorinated ethylene propylene (FEP) and/or a multilayer film comprising one or more of the aforementioned polymers.

15. A module according to any one of the preceding claims, **characterised in that** the encapsulating assembly (3), the front interface layer (2b; 2d) and/or the optional rear interface layer (5b) are formed by at least one layer comprising at least one polymeric encapsulation material selected from: acid copolymers, ionomers, poly(ethylene-vinyl acetate) (EVA), vinyl acetals, such as polyvinyl butyrals (PVB), polyurethanes, polyvinyl chlorides, polyethylenes, such as linear low-density polyethylenes, elastomeric polyolefin copolymers, copolymers of α-olefins and ethylene-based α-, β-carboxylic acid esters, such as ethylene-methyl acrylate copolymers and ethylene-butyl acrylate copolymers, silicone elastomers and/or elastomers based on cross-linked thermoplastic polyolefin.

16. A module according to any of the preceding claims, **characterised in that** the first layer (2) comprises:
- a first front assembly (2b, 2c) comprising a front interface layer (2b) and a front glass layer (2c), the front glass layer (2c) having a thickness (e_{2c}) of 2 mm or less,
- a second front assembly (2d, 2e) comprising a front interface layer (2d) and a front glass layer (2e), the front glass layer (2e) having a thickness (e₂ₑ ) of 2 mm or less,
the first front assembly (2b, 2c) being situated between the front polymer layer (2a) and the second front assembly (2d, 2e), which is itself situated between the first front assembly (2b, 2c) and the encapsulating assembly (3).

17. A module according to claim 16, **characterised in that** the thickness (e_{2c} ) of the front glass layer (2c) of the first front assembly (2b, 2c) and the thickness (e₂ₑ ) of the front glass layer (2e) of the second front assembly (2d, 2e) are different.

18. A module according to claim 17, **characterised in that** the thickness (e_{2c} ) of the front glass layer (2c) of the first front assembly (2b, 2c) is greater than the thickness (e₂ₑ ) of the front glass layer (2e) of the second front assembly (2d, 2e).

19. A module according to any one of the preceding claims, **characterised in that** the second layer (5) comprises:
- a rear layer made of at least one polymeric material (5a), referred to as the "polymeric rear layer (5a)", and
- a first rear assembly (5b, 5c) comprising a rear interface layer (5b) and a rear glass layer (5c), the rear glass layer (5c) having, in particular, a thickness (e_{5c} ) of 2 mm or less, in particular 1.5 mm or less, in particular between 500 µm and 1.1 mm, in particular further between 500 µm and 1 mm, in particular further between 300 µm and 700 µm, in particular further between 300 µm and 500 µm, and being in particular made of non-tempered glass,
- a second rear assembly comprising a rear interface layer and a rear glass layer, the rear glass layer having, in particular, a thickness of 2 mm or less, in particular 1.5 mm or less, in particular between 500 µm and 1.1 mm, in particular between 500 µm and 1 mm, in particular between 300 µm and 700 µm, in particular between 300 µm and 500 µm, and being in particular made of non-tempered glass,
said first rear assembly (5b, 5c) being situated between the polymeric rear layer (5a) and the second rear assembly, which is itself situated between the first rear assembly (5b, 5c) and the encapsulating assembly (3).

20. A method of manufacturing a photovoltaic module (1) according to any one of the preceding claims, from a stack comprising:
- a first transparent layer (2) forming the front face of the photovoltaic module (1), intended to receive a light flux,
- a plurality of photovoltaic cells (4) arranged side by side and electrically connected to one another,
- an encapsulating assembly (3) for the plurality of photovoltaic cells (4),
- a second layer (5), the encapsulating assembly (3) and the plurality of photovoltaic cells (4) being situated between the first (2) and second (5) layers,
**characterised in that** the first layer (2) comprises:
- a front layer made of at least one polymeric material (2a), referred to as the "polymeric front layer (2a)", and
- at least one front assembly (2b, 2c; 2d, 2e) comprising a front interface layer (2b; 2d) and a front glass layer (2c; 2e), the front glass layer (2c; 2e) having a thickness (e_{2c} ; e₂ₑ ) of 2 mm or less,
said at least one front assembly (2b, 2c; 2d, 2e) being situated between the front polymer layer (2a) and the encapsulating assembly (3), and the front interface layer (2b; 2d) of said at least one front assembly (2b, 2c; 2d, 2e) being situated between the front polymer layer (2a) and the front glass layer (2c; 2e),
**characterised in that** the front glass layer (2c; 2e) has rounded edges at its corners.
